# EUROPEAN PATENT APPLICATION

(11) **EP 4 369 874 A1**
(43) Date of publication of application: **15.05.2024**
(21) Application number: 22849264.1
(22) Date of filing: 13.07.2022
(51) Int. Cl.: H05K 1/02, H05K 3/00

(54) **BONDED SUBSTRATE, CIRCUIT BOARD AND MANUFACTURING METHOD THEREFOR, AND INDIVIDUAL SUBSTRATE AND MANUFACTURING METHOD THEREFOR**

(30) Priority: 26.07.2021 JP 2021121333
(71) Applicant: Denka Company Limited, Tokyo 103-8338 (JP)
(72) Inventor: YUASA, Akimasa, Tokyo 103-8338 (JP)
(74) Representative: Hoffmann Eitle
(86) International application number: PCT/JP2022/027620
(87) International publication number: WO 2023/008200

(57) **Abstract**

Provided is a circuit substrate including a circuit formation portion and a dummy portion, the circuit substrate including: a ceramic plate and a plurality of conductor portions joined to a main surface of the ceramic plate, in which the plurality of conductor portions include a first conductor portion provided on the dummy portion and a second conductor portion provided on the circuit formation portion, and in which a surface of the first conductor portion has a first identification mark. A part of an outer edge of the first conductor portion in the dummy portion protrudes outward from the main surface of the ceramic plate.

## Description

### Technical Field

The present disclosure relates to a joined substrate, a circuit substrate and a method for manufacturing the same, and an individual substrate and a method for manufacturing the same.

### Background Art

An insulating ceramic substrate may be used for an individual substrate to be mounted on electronic devices. As a multi-piece wiring substrate for obtaining such an individual substrate, there is known one in which a plurality of wiring substrate regions are arranged vertically and horizontally, a dummy region is provided in an outer peripheral portion, and a symbol pattern consisting of a void is provided in an inner layer of each wiring substrate region (for example, Patent Document 1). If such a symbol pattern is analyzed using an ultrasonic flaw detector, an X-ray, or the like, the arrangement position of the wiring substrate region can be detected.

In addition, there is known a manufacturing method including a step of drawing a barcode or a two-dimensional code by irradiating a part of a ceramic green sheet used as a material of an individual substrate with laser beam, a step of obtaining a ceramic substrate including a plurality of substrate formation regions by firing the ceramic green sheet, and a step of dividing the ceramic substrate (for example, Patent Documents 2 and 3). Accordingly, the molding lot number can be associated with the final product.

### Citation List

### Patent Literature

[Patent Document 1] Japanese Unexamined Patent Publication No. 2005-210028
[Patent Document 2] PCT International Publication No. WO2020/179699
[Patent Document 3] PCT International Publication No. WO2021/020471

### Summary of Invention

### Technical Problem

Identification marks such as symbol patterns and two-dimensional codes described in Patent Documents 1 to 3 are considered to be useful for achieving traceability. Accordingly, the present disclosure provides a circuit substrate and a method for manufacturing the same that are excellent in traceability. Further, provided is the joined substrate excellent in traceability. Yet further, provided is an individual substrate and a method for producing the same that are excellent in traceability.

### Solution to Problem

The present disclosure provides in some aspects the following [1] to [13].
[1] A circuit substrate including a circuit formation portion and a dummy portion, the circuit substrate comprising:
   a ceramic plate and a plurality of conductor portions joined to a main surface of the ceramic plate,
   wherein the plurality of conductor portions include a first conductor portion provided on the dummy portion and a second conductor portion provided on the circuit formation portion, and
   wherein the surface of the first conductor portion has a first identification mark.
[2] The circuit substrate according to [1], wherein a part of an outer edge of the first conductor portion in the dummy portion surrounding the circuit formation portion protrudes outward from the main surface of the ceramic plate.
[3] The circuit substrate according to [1] or [2], wherein the plurality of conductor portions includes a third conductor portion provided on the dummy portion and does not have the first identification mark.
[4] The circuit substrate according to any one of [1] to [3], wherein a surface of the second conductor portion has a second identification mark, and the second identification mark includes second information related to first information included in the first identification mark.
[5] The circuit substrate according to any one of [1] to [4], wherein the first identification mark includes a code formed of a laser hole, and the laser hole has a depth of 1 µm or more.
[6] A joined substrate, comprising: a ceramic plate having a main surface including a circuit formation region and a dummy region; and a metal plate joined to the ceramic plate so as to cover the main surface, wherein the metal plate has a third identification mark on a surface of a portion covering the dummy region.
[7] The joined substrate according to [6], wherein a part of an outer edge of the metal plate protrudes outward from the main surface of the ceramic plate, and wherein a corner portion of the ceramic plate protrudes outward from the metal plate.
[8] The joined substrate according to [6] or [7], further having a fourth identification mark on a surface of a portion covering the circuit formation region, wherein the fourth identification mark includes fourth information related to third information included in the third identification mark.
[9] The joined substrate according to any one of [6] to [8], wherein the third identification mark includes a code formed of a laser hole, and the laser hole has a depth of 3 µm or more.
[10] An individual substrate comprising a second conductor portion obtained by separating the dummy portion from a circuit substrate including a dummy portion having a first conductor portion and a circuit formation portion having the second conductor portion, ,
   wherein a surface of the second conductor portion has a second identification mark including second information related to first information included in a first identification mark on the surface of the first conductor portion.
[11] The individual substrate according to [10], wherein the second identification mark includes a code formed of a laser hole, and the laser hole has a depth of 1 µm or more.
[12] A method for manufacturing a circuit substrate, the method comprising: a step of performing at least an etching process on the joined substrate according to any one of [6] to [9] to form a first conductor portion and a second conductor portion on the dummy region and the circuit formation region, respectively, and to obtain a circuit substrate having a dummy portion including the first conductor portion and a circuit formation portion including the second conductor portion,
   wherein the surface of the first conductor portion has a first identification mark derived from the third identification mark.
[13] A method for manufacturing an individual substrate, the method comprising:
   a step of performing at least an etching process on the joined substrate according to any one of [6] to [9] to form a first conductor portion and a second conductor portion on the dummy region and the circuit formation region, respectively, to obtain a circuit substrate including a dummy portion including the first conductor portion and a circuit formation portion including the second conductor portion; and
   a step of separating the dummy portion from the circuit substrate to obtain an individual substrate including the second conductor portion,
   wherein the surface of the first conductor portion has a first identification mark derived from the third identification mark.

The circuit substrate according to [1] can ensure, by providing the dummy portion with a first conductor portion having a first identification mark, traceability without providing the circuit formation portion with an identification mark. In addition, since the first identification mark is provided on the surface of the first conductor portion, it is possible to increase reading accuracy compared to a case where the identification mark is provided inside the circuit surface. Accordingly, the circuit substrate is highly traceable.

The circuit substrate may have a configuration according to [2]. Accordingly, even in a case where the first conductor portion and the main surface of the ceramic plate are joined to each other via the brazing layer, it is possible to prevent contamination of the first identification mark due to oozing of the brazing material to the surface of the first conductor portion. Therefore, the reading accuracy of the first identification mark can be maintained sufficiently high.

The circuit substrate may have a configuration according to [3]. By including the third conductor portion, when the first conductor portion and the second conductor portion are formed by etching, it is possible to reduce unevenness in etching rate and improve uniformity of the shape of the second conductor portion provided on the circuit formation portion.

The circuit substrate may have a configuration according to [4]. Since such a circuit substrate has the second identification mark on the surface of the second conductor portion, it is possible to increase the reading accuracy compared to a case where an identification mark is provided inside the circuit formation portion. In addition, since the second identification mark includes the second information related to the first information included in the first identification mark, it is possible to secure the traceability of the circuit formation portion (individual substrate) obtained by separating the dummy portion from the circuit substrate. Further, the circuit substrate and the circuit formation portion (individual substrate) obtained by separating the dummy portion from the circuit substrate can be managed in association with each other. Therefore, the range of traceability can be expanded.

The circuit substrate may have a configuration according to [5]. Accordingly, even when the surface treatment is performed, the reading accuracy can be sufficiently maintained. Therefore, the reliability of the traceability can be sufficiently improved.

The joined substrate according to [6] described above is excellent in traceability because the joined substrate has a third identification mark on the surface of the metal plate. In addition, since the metal plate has the third identification mark on the surface of the portion covering the dummy region, it is possible to ensure traceability without providing an identification mark on the portion supposed to be the circuit formation portion.

The joined substrate may have a configuration according to [7]. Since a part of the outer edge of the metal plate protrudes from the main surface of the ceramic plate, even in a case where the metal plate and the main surface of the ceramic plate are joined to each other via the brazing layer, it is possible to prevent the third identification mark from being covered by the brazing material oozing to the surface of the metal plate. Accordingly, the reading accuracy of the third identification mark can be maintained at a sufficiently high level. In addition, since the corner portion of the ceramic plate is exposed, the alignment can be performed using the corner portion. The joined substrate, and a circuit substrate and an individual substrate obtained therefrom are excellent in dimensional accuracy.

The joined substrate may have a configuration according to [8]. Accordingly, the range of traceability can be expanded. For example, traceability can be ensured even after the dummy portion and the circuit formation portion are formed by etching and the dummy portion and the circuit formation portion are separated.

The joined substrate may have a configuration according to [9]. Accordingly, even after the surface treatment and the etching treatment are performed on the joined substrate, it is possible to sufficiently maintain the reading accuracy of the identification mark derived from the third identification mark. Thus, the reliability of the traceability can be sufficiently improved.

The individual substrate of [10] described above has the second identification mark on the surface in the second conductor portion. The second identification mark can improve the reading accuracy as compared with a case where an identification mark is provided inside an individual substrate. In addition, since the second identification mark includes the second information related to the first information included in the first identification mark, it is possible to manage the circuit substrate or the dummy portion and the individual substrate in association with each other, and it is possible to expand the range of traceability. Therefore, the individual substrate is highly traceable.

The individual substrate may have a configuration according to [11]. Accordingly, the reading accuracy can be improved and the reliability of traceability can be sufficiently improved.

In the method for manufacturing a circuit substrate according to [12] described above, the joined substrate has the third identification mark on the surface of the metal plate, and the circuit substrate has the first identification mark derived from the third identification mark on the surface of the first conductor portion. Accordingly, traceability from the joined substrate to the circuit substrate can be ensured. In addition, since the first identification mark and the third identification mark are provided on the surface of the conductor portion and the metal plate, the reading accuracy is excellent. Therefore, the method for manufacturing the circuit substrate is excellent in traceability.

In the method for manufacturing an individual substrate according to [13] described above, the joined substrate has the third identification mark on the surface of the metal plate, and the circuit substrate has the first identification mark derived from the third identification mark on the surface of the first conductor portion. Accordingly, traceability from the joined substrate to the circuit substrate can be ensured. Further, the first identification mark and the third identification mark are excellent in reading accuracy. Accordingly, the method for manufacturing the individual substrate is excellent in traceability.

### Advantageous Effects of Invention

A circuit substrate and a method for manufacturing the same that are excellent in traceability are provided. Further, a joined substrate excellent in traceability is provided. Yet further, an individual substrate and a method for producing the same that are excellent in traceability are provided.

### Brief Description of Drawings

FIG. 1 is a perspective view of a joined substrate according to one embodiment.
FIG. 2 is a diagram illustrating an example of an identification mark.
FIG. 3 is a cross-sectional view of the joined substrate of FIG. 1 taken along line III-III.
FIG. 4 is a plan view of a ceramic plate.
FIG. 5 is a plan view of a circuit substrate according to one embodiment.
FIG. 6 is a cross-sectional view of the circuit substrate of FIG. 5 taken along line VI-VI.
FIG. 7 is a plan view of a joined substrate according to another embodiment.
FIG. 8 is a plan view of a circuit substrate according to another embodiment.
FIG. 9 is a perspective view of an individual substrate according to one embodiment.

### Description of Embodiments

Hereinafter, an embodiment of the present disclosure will be described with reference to the drawings as the case may be. However, the following embodiment is an example for describing the present disclosure and are not intended to limit the present disclosure to the following contents. In the description, the same reference numerals are used for the same elements or elements identical in terms of function with redundant description omitted as the case may be. In addition, positional relationships including up, down, left, and right are based on positional relationships illustrated in the drawings unless otherwise noted. The dimensional ratio of each element is not limited to the illustrated ratio. The upper limit or the lower limit of the numerical range specified in the present specification may be replaced by any value shown in the examples. In addition, the upper limit value and the lower limit value described individually may be arbitrarily combined.

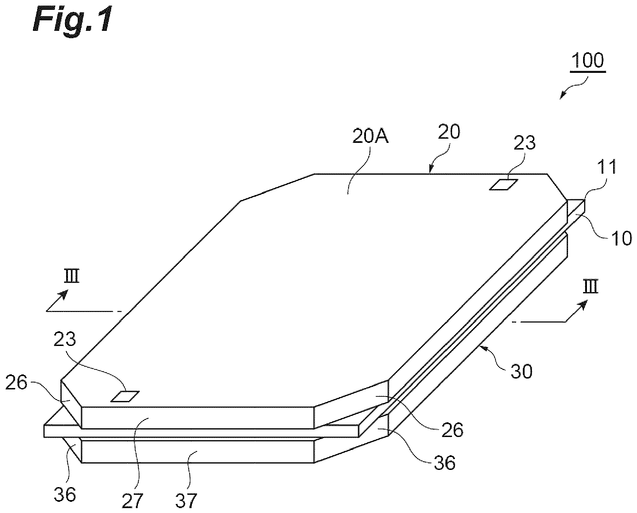

FIG. 1 is a perspective view of a joined substrate 100 according to one embodiment. The joined substrate 100 of FIG. 1 includes a ceramic plate 10 and a pair of metal plates 20 and 30 joined to the ceramic plate 10 to cover both main surfaces of the ceramic plate 10 respectively. The pair of metal plates 20 and 30 may be, for example, a copper plate or an aluminum plate. The joined substrate 100 has a third identification mark 23 on a surface 20A of the metal plate 20. The joined substrate 100 may or may not have a similar identification mark on the surface of the metal plate 30. Two third identification marks 23 are illustrated on the surface 20A, but the number is not limited, and may be one or three or more.

The third identification mark 23 may be any mark that allows identifying the metal plate 20 and the joined substrate 100. For example, the third identification mark 23 may be a one-dimensional code such as a barcode or a two-dimensional code. The third identification mark 23 may be printed on the surface 20A, or may be formed in a rugged shape. For example, the third identification mark 23 may be a recessed portion and a pattern. A plurality of third identification marks 23 may be the same as or different from each other.

The third identification mark 23 is configured to be detected by an imaging device such as a camera or video, for example. The imaging device may include, for example, an information processing unit that collates a captured image with information recorded in advance and outputs information based on the collation result. The same applies to other identification marks in the present disclosure.

The third identification mark 23 may be used to identify the joined substrate 100 and a circuit substrate 200 described below. If the third identification mark 23 is provided on the surface of the metal plates 20 and 30 before the joined substrate 100 is manufactured, the metal plates 20 and 30 can be identified. The third identification mark 23 may be a code associated with some information. The information may relate to, for example, a lot, manufacturing history, product type, application, quality, and manufacturing conditions. By using the third identification mark 23, traceability of the metal plates 20 and 30, the joined substrate 100, and various products obtained therefrom can be improved. For example, the third identification mark 23 may be used to provide quality control and process control.

The third identification mark 23 may be, for example, one in which one or two or more of the following pieces of information (a), (b), (c), (d), (e), and (f) are encoded.
(a) Information about the metal plate
(b) Manufacturing information of joined substrate (manufactured date, manufacturing condition, manufacturing facility, etc.)
(c) Quality information of the joined substrate
(d) Surface treatment conditions of the joined substrate
(e) Etching conditions of the joined substrate
(f) Serial number of the joined substrate

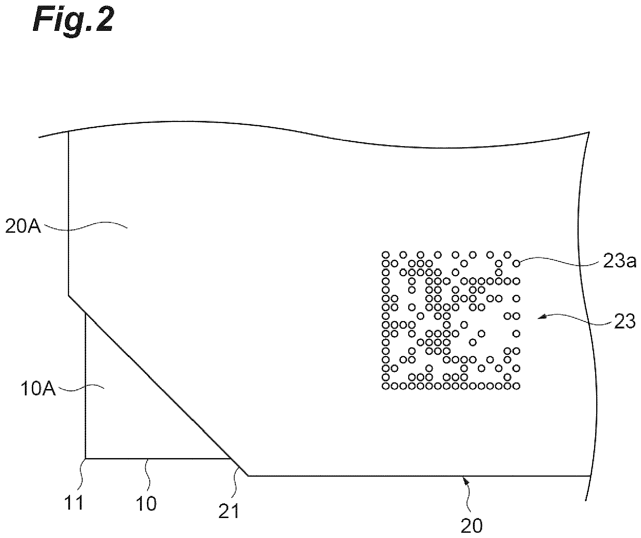

FIG. 2 is a diagram illustrating an example of the third identification mark 23. The third identification mark 23 is a two-dimensional code and formed of a plurality of recessed portions 23a arranged in accordance with a predetermined rule. The third identification mark 23 may be, for example, a two-dimensional barcode such as QR code (registered trademark). In addition, the third identification mark 23 may be a three-dimensional code using, for example, information related to the depth of the recessed portions 23a. The recessed portions 23a may be laser holes formed by a laser beam. As the laser source, for example, a carbon dioxide gas laser, a YAG laser or the like can be used. The third identification mark 23 is not limited to one formed of the recessed portion 23a.

The depth of the recessed portion 23a constituting the third identification mark 23 may be 3 µm or more, and may be 5 µm or more. Accordingly, sufficient reading accuracy can be ensured even after surface treatment such as chemical polishing is performed. The depth of the recessed portion 23a may be 50 µm or less, 30 µm or less, or less than 10 µm. By reducing the depth in this manner, it is possible to shorten the time for forming the laser hole and to reduce the amount of foreign matter (dross) generated due to the formation of the laser hole.

The code size of the third identification mark 23 may be 1 to 4 mm on each side in a plan view. Accordingly, it is possible to sufficiently maintain the detection accuracy of the imaging device and to make the size sufficiently fit in the surface of the portion covering a dummy region 15 of the ceramic plate 10 described below. From the viewpoint of ensuring a quantity of information while having such a size, the number of cells (the maximum number of the recessed portions 23a arranged along one direction) may be 5 to 30, or may be 10 to 20.

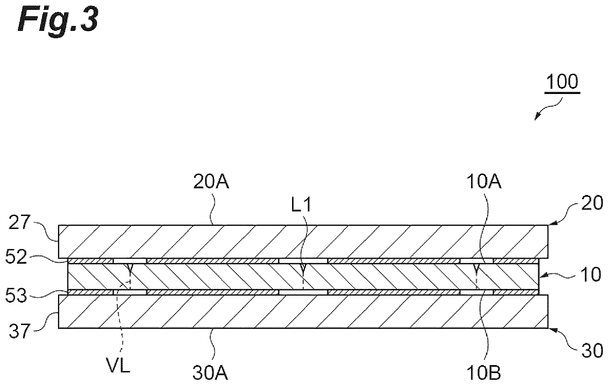

As illustrated in the cross-sectional view of FIG. 3, the metal plate 20 and the metal plate 30 are joined to a main surface 10A and a main surface 10B of the ceramic plate 10 via brazing layers 52 and 53, respectively. An outer edge 27 and an outer edge 37 of the metal plate 20 and the metal plate 30 protrude outward from the main surface 10A and the main surface 10B of the ceramic plate 10. Accordingly, it is possible to prevent oozing of the brazing material components into the surface 20A of the metal plate 20 and the surface 30A of the metal plate 30. Therefore, it is possible to prevent the third identification mark 23 on the surface 20A of the metal plate 20 from being covered with the brazing material components. Such a third identification mark 23 is excellent in reading accuracy. Further, in a case where the identification mark is provided on the surface 30A of the metal plate 30, it is possible to prevent the identification mark from being covered with the brazing material components.

In FIG. 3, the brazing layers 52 and 53 are provided only in a portion corresponding to a conductor portion when the circuit substrate is manufactured. That is, there is a gap between adjacent brazing layers. In a modification, such a gap portion does not need to be provided.

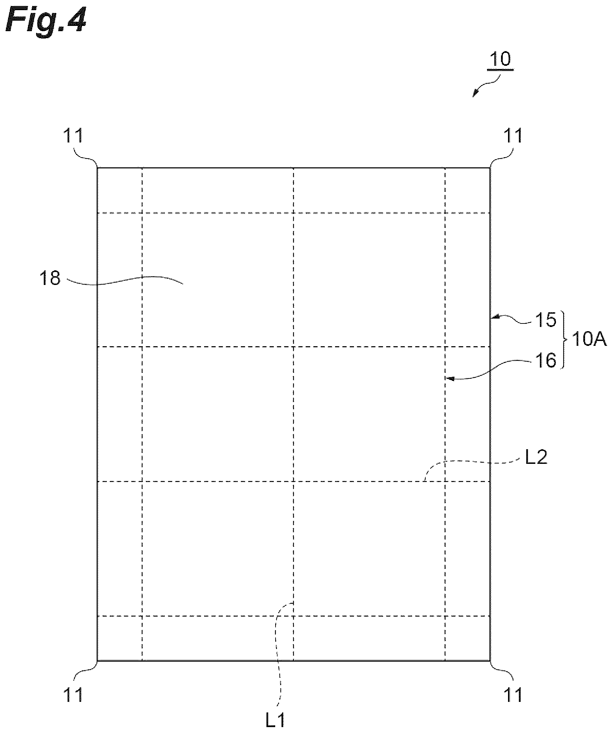

As illustrated in FIG. 4, the main surface 10A of the ceramic plate 10 is rectangular, and is divided into a plurality of sections by division lines. On the main surface 10A, a plurality of division lines L1 extending along a first direction and arranged at equal intervals and a plurality of division lines L2 extending along a second direction perpendicular to the first direction and arranged at equal intervals are provided as the division lines. The division lines L1 and the division lines L2 are perpendicular to each other.

For example, the division lines L1 and L2 may be configured such that, for example, a plurality of recesses are linearly arranged, or a groove may be linearly formed. Specifically, the scribe line may be formed by a laser beam. Examples of the laser source include a carbon dioxide gas laser and a YAG laser. A scribe line can be formed by intermittently irradiating a laser beam from such a laser source. The division lines L1 and L2 do not need to be arranged at equal intervals, and are not limited to being perpendicular to each other. The division lines L1 an dL2 may be curved or bent instead of a straight line. In FIG. 4, the division lines L1 and L2 are provided only on one main surface 10A of the ceramic plate 10, but the division lines L1 and L2 may also be formed on the other main surface 10B of the ceramic plate 10.

As illustrated in FIG. 4, the ceramic plate 10 has: a circuit formation region 16 including six sections 18 defined by two division lines L1 positioned outermost and two division lines L2 positioned outermost; and the dummy region 15 surrounding the circuit formation region 16. A conductor portion serving as a circuit may be formed in each of the six sections 18. The metal plate 20 in the joined substrate 100 of FIG. 1 has the third identification mark 23 on the surface of the portion of the surface 20A that covers the dummy region 15 of the ceramic plate 10. That is, the third identification mark 23 illustrated in FIGS. 1 and 2 is provided above the dummy region 15 of the ceramic plate 10. On the other hand, the metal plate 20 does not have an identification mark on the surface of a portion of the surface 20A covering the circuit formation region 16 of the ceramic plate 10. Accordingly, it is possible to avoid the identification mark from becoming an obstacle when testing the joining state between the main surface 10A and the conductor portion which is provided in the circuit formation region 16 of the ceramic plate 10 and serves as a circuit. Therefore, it is possible to sufficiently increase the inspection accuracy of the joined state of the conductor portion. Accordingly, it is possible to obtain a circuit substrate and an individual substrate having excellent reliability.

As illustrated in FIG. 1, in the joined substrate 100, corner portions 11 of the ceramic plate 10 protrude outward from the pair of metal plates 20 and 30. Four corner portions of each of the pair of metal plates 20 and 30 are chamfered. The corner portions 11 of the ceramic plate 10 are exposed between chamfered portions 26 and 36 of the pair of metal plates 20 and 30. The shape of the chamfered portions 26 and 36 is not particularly limited, and may be, for example, a C-chamfered shape or an R-chamfered shape. The shape of the pair of metal plates 20 and 30 may be the same or different.

The position of the corner portion 11 of the ceramic plate 10 can be easily detected when the joined substrate 100 is viewed in plan view. Accordingly, by using the corner portion 11 as a reference for positioning the joined substrate 100, the joined substrate 100 can be processed smoothly and with high accuracy. As a result, a processed product excellent in dimensional accuracy can be smoothly manufactured.

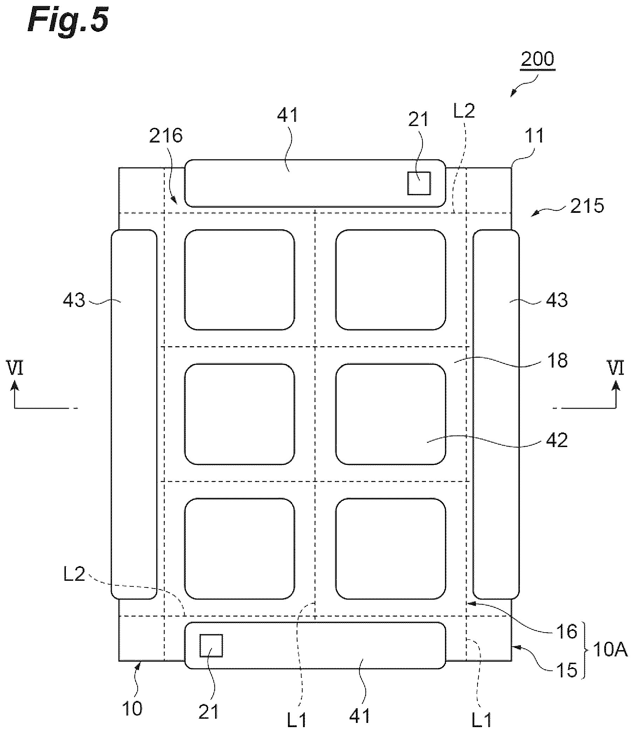

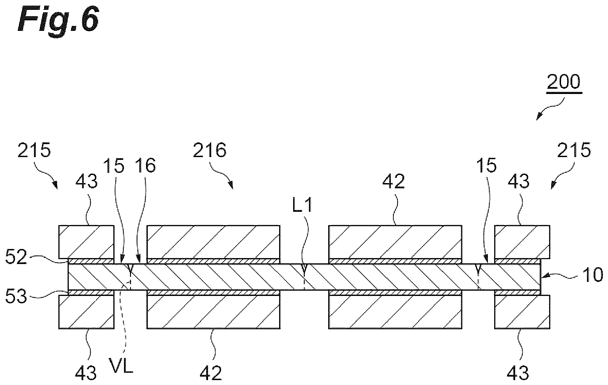

From the circuit substrate 200 illustrated in FIGS. 5 and 6, a plurality of individual substrates are obtained by dividing the ceramic plate 10 along the division lines L1 and L2. In this case, the ceramic plate 10 is cut along a virtual line VL illustrated in FIG. 6. The circuit substrate 200 are also referred to as multi-piece circuit substrate. The circuit substrate 200 may be obtained by processing the joined substrate 100 of FIG. 1. The circuit substrate 200 includes a circuit formation portion 216 including the circuit formation region 16 of the ceramic plate 10 and a dummy portion 215 including the dummy region 15 of the ceramic plate 10. The circuit formation portion 216 includes six second conductor portions 42 on each of the main surfaces 10A and 10B. The plurality of second conductor portions 42 are provided independently for each section 18.

As illustrated in FIG. 5, the dummy portion 215 surrounding the circuit formation portion 216 includes a first conductor portion 41 and a third conductor portion 43. A total of four first conductor portions 41 and the third conductor portions 43 are provided along each side forming the outer edge of the rectangular main surface 10A of the ceramic plate 10. Two first conductor portions 41 facing each other on the main surface 10A have a first identification mark 21 on the surface thereof. If the circuit substrate 200 is obtained by processing the joined substrate 100, the first identification mark 21 may be derived from the third identification mark 23 of FIG. 1. That is, the first identification mark 21 and the third identification mark 23 may be exactly the same, or may be discolored or deformed by a working process for obtaining the circuit substrate 200 from the joined substrate 100. The shape and function of the first identification mark 21 and the third identification mark 23 may be the same.

The first identification mark 21 may be any mark as long as the circuit substrate 200 can be identified. For example, the code may be a one-dimensional code such as a barcode or a two-dimensional code. The first identification mark 21 may be printed on the surface of the first conductor portion 41, or may be formed in a rugged shape. For example, a recessed portion and a pattern may be combined. The plurality of first identification marks 21 may be the same as or different from each other.

The first identification mark 21 may be used to identify the circuit substrate 200. The first identification mark 21 may be a code associated with some information. The information may relate to, for example, a lot, manufacturing history, product type, application, quality, and manufacturing conditions. By using the first identification mark 21, the traceability of the circuit substrate 200 can be improved. The first identification mark 21 may be used for quality control and process control.

The first identification mark 21 may be, for example, one in which one or two or more of the following pieces of information (a), (b), (c), and (d) are encoded.
(a) Information of the joined substrate used (information of the metal plate)
(b) Manufacturing information of the circuit substrate (manufactured date, manufacturing condition, manufacturing facility, and the like)
(c) Quality information of the circuit substrate
(d) Division condition of the circuit substrate

Since the first identification mark 21 of the circuit substrate 200 is provided on the surface of the first conductor portion 41, reading is easy and accurate. The code size and number of cells in the first identification mark 21 may be the same as those of the third identification mark 23. If the first identification mark 21 is formed of a recessed portion like the recessed portion 23a illustrated in FIG. 2, the depth of the recessed portion may be 1 µm or more, or may be 3 µm or more. The depth of the recessed portion constituting the first identification mark 21 may be smaller than the depth of the recessed portion 23a constituting the third identification mark 23. This is because the circuit substrate 200 is not subjected to a surface treatment like the joined substrate 100. The depth of the recessed portion of the first identification mark 21 may be 50 µm or less, 30 µm or less, or less than 10 µm from the same view point as that of the recessed portion 23a.

The first conductor portion 41 may extend outside the main surface 10A and the main surface 10B of the ceramic plate 10. The first identification mark 21 provided on the surface (upper surface) of the first conductor portion 41 is prevented from being covered with the brazing material components. Such a first identification mark 21 is excellent in reading accuracy.

Of the four conductor portions provided on the dummy portion 215, the remaining two third conductor portion 43 facing each other do not have identification marks on the surface thereof. The advantage of providing such a third conductor portion 43 having no identification mark on the dummy portion 215 are as follows. When the circuit substrate 200 is obtained by etching, the etching rate becomes faster as the exposed area of the dissolved metal plate becomes larger. For this reason, if the third conductor portion 43 is not provided, the etching rate in the vicinity of the side surface close to the dummy portion 215 among the respective side surfaces of the second conductor portion 42 in the circuit formation portion 216 of the circuit substrate 200 increases, and unevenness in the side surface shapes and thicknesses of the second conductor portion 42 occurs. Therefore, by providing the third conductor portion 43, it is possible to reduce the difference in etching rate between the portion close to the dummy portion 215 and the portion away from the dummy portion. This can improve the uniformity of the shape of the second conductor portion 42 in the circuit formation portion 216. That is, by providing the third conductor portion 43 on the dummy portion 215, it is possible to reduce unevenness in the shape of the second conductor portion 42. The shape of the third conductor portion 43 is not particularly limited.

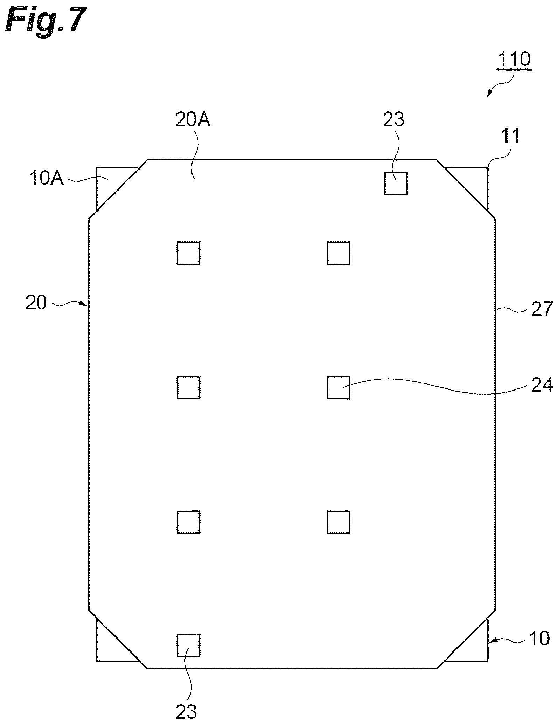

FIG. 7 is a plan view of a joined substrate 110 according to another embodiment. The joined substrate 110 of FIG. 7 differs from the joined substrate 100 in that it has six fourth identification marks 24 on the surface 20A in the metal plate 20 in addition to the third identification marks 23. The other components of the joined substrate 110 may be the same as the joined substrate 100. The fourth identification marks 24 are provided on the circuit formation region 16 in the main surface 10A of the ceramic plate 10. As illustrated in FIG. 4, the circuit formation region 16 includes a plurality of sections 18. One fourth identification mark 24 is provided above each of the plurality of sections 18.

The shape and function of the fourth identification mark 24 may be the same as or different from those of the third identification mark 23. The fourth identification mark 24 may be any mark that allows identifying the metal plate 20 and the joined substrate 110. For example, the fourth identification mark 24 may be a one-dimensional code such as a barcode or a two-dimensional code. The fourth identification mark 24 may be printed on the surface 20A, or may be formed in a rugged shape. For example, a recessed portion and a pattern may be combined. The plurality of fourth identification marks 24 may be the same as or different from each other.

The fourth identification mark 24 is provided on the surface of a portion of the surface 20A of the metal plate 20 that covers the circuit formation region 16. This makes it possible to ensure traceability even after the individual substrate is obtained by dividing the circuit substrate obtained by etching or the like along the division lines L1 and L2.

The fourth identification mark 24 of the joined substrate 110 is easy and accurate to read because the fourth identification mark 24 is provided on the surface 20A of the metal plate 20. The code size and number of cells in the fourth identification mark 24 may be the same as those of the third identification mark 23. When the fourth identification mark 24 is formed of a recessed portion like the recessed portion 23a illustrated in FIG. 2, the depth of the recessed portion may be 3 µm or more, or may be 5 µm or more. The depth of the recessed portion constituting the fourth identification mark 24 may be 50 µm or less, 30 µm or less, or less than 10 µm from the same viewpoint as that of the recessed portion 23a.

In a modification, the fourth identification mark 24 may disappear by the joined substrate 110 to a surface treatment or the like. Thus, it is possible to obtain the circuit substrate and the individual substrate in which the identification mark does not remain in the circuit formation portion and the individual substrate. In this case, the depth of the recessed portion constituting the fourth identification mark 24 may be smaller than the depth of the recessed portion constituting the third identification mark 23. The fourth identification mark 24 may be a two-dimensional mark and the third identification mark 23 may be a three-dimensional mark.

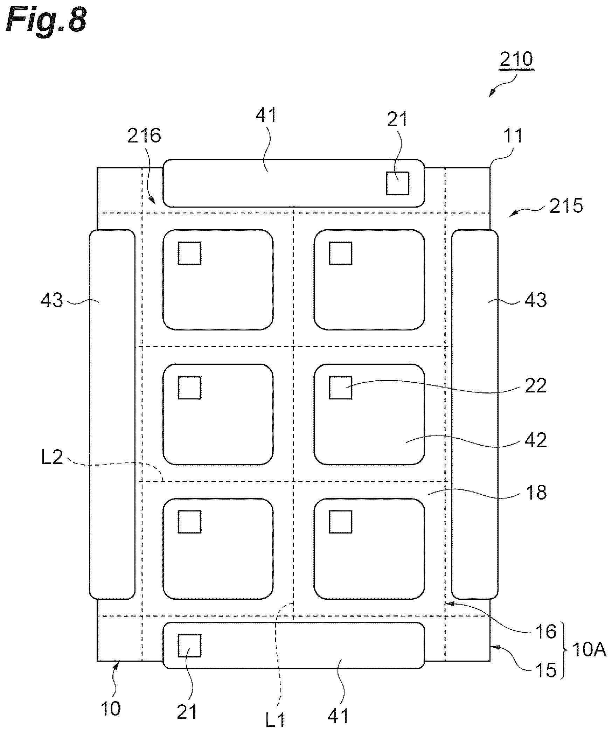

FIG. 8 is a plan view of a circuit substrate 210 according to another embodiment. The circuit substrate 210 of FIG. 8 differs from the circuit substrate 200 of FIGS. 5 and 6 in having second identification marks 22 on the surface of the second conductor portion 42 in addition to having the first identification mark 21 on the surface of the first conductor portion 41. Other configurations of the circuit substrate 210 may be the same as those of the circuit substrate 200 of FIGS. 5 and 6. The circuit substrate 210 may be obtained by processing the joined substrate 110. If the circuit substrate 210 is obtained by processing the joined substrate 110, the first identification mark 21 and the second identification mark 22 may be derived from the third identification mark 23 and the fourth identification mark 24 of FIG. 7. That is, the second identification mark 22 and the fourth identification mark 24 may be exactly the same, or may be discolored or deformed by a working process for obtaining the circuit substrate 210 from the joined substrate 110.

The circuit substrates 200 and 210 include, but is not limited to, the first conductor portion 41 having, in the dummy portion 215, the first identification mark 21 and the third conductor portion 43 having no identification mark. For example, all four conductor portions on the main surface 10A may have the first identification mark 21. Further, it is not necessary to have a conductor portion along all four sides of the main surface 10A of the ceramic plate 10. In a modification, there may be a conductor portion along any one side. In another modification, the third conductor portion 43 may be provided only on the main surface 10A and not on the main surface 10B. The shapes of the second conductor portions 42 provided on the main surface 10A and the main surface 10B may be the same as each other or may be different from each other.

The circuit substrates 200 and 210 are divided along the division lines L1 and L2 of the ceramic plate 10, and the circuit formation portion 216 and the dummy portion 215 are separated. The circuit formation portion 216 is divided into a unit of the section 18 and becomes six individual substrates. The individual substrate is used as a component of a power module or the like, for example. Since the corner portions 11 of the ceramic plate 10 are exposed in the circuit substrates 200 and 210, for example, it is possible to improve alignment accuracy when obtaining individual substrate by division. Although six individual substrates can be obtained from the circuit substrates 200 and 210, the number thereof is not particularly limited. For example, only one second conductor portion 42 may be provided in the circuit formation portion, and only one individual substrate may be obtained from the circuit substrates 200 and 210. In addition, for example, the circuit formation portion may include nine (3 rows × 3 columns) or more sections 18 and the second conductor portions 42, and nine or more individual substrates may be obtained by division.

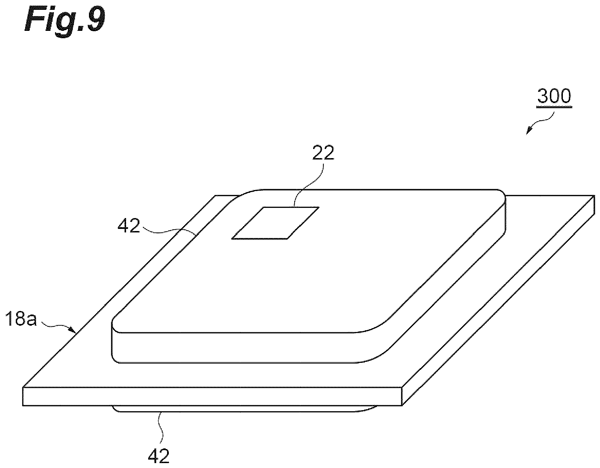

An individual substrate 300 illustrated in FIG. 9 may be obtained by dividing the circuit substrate 210 along the division lines L1 and L2, for example. That is, the individual substrate 300 may be obtained by separating the dummy portion 215 from the circuit substrate 210. The individual substrate 300 includes a divided plate 18a (ceramic plate) derived from the section 18 of the ceramic plate 10 and a pair of the second conductor portion 42 so as to sandwich the divided plate 18a. The individual substrate 300 has the second identification mark 22 on the surface of at least one second conductor portion 42. Since the second identification mark 22 is provided on the surface of the second conductor portion 42, it is possible to improve reading accuracy compared to a case where the identification mark is provided inside the individual substrate. Therefore, the traceability is excellent.

The second information included in the second identification mark 22 of the individual substrate 300 and the first information included in the first identification mark 21 provided on the surface of the first conductor portion 41 of the dummy portion 215 may include information related to each other. The "information related to each other" may be any information as long as it allows grasping that the first identification mark 21 and the second identification mark 22 belong to the same circuit substrate 210.

For example, it is assumed that there are n pieces of the circuit substrates 210. The first identification mark 21 and the second identification mark 22 of the first the circuit substrate 210 include common unique information 1 as the "information related to each other". The first identification mark 21 and the second identification mark 22 of the k-th the circuit substrate 210 include common unique information k as the "information related to each other". Since the unique information 1 and the unique information k are different from each other, even after n pieces of the circuit substrates 210 are divided and 6n pieces of the individual substrate 300 are obtained, it is possible to grasp which of n pieces of the circuit substrates 200 each of the 6n pieces of the individual substrates 300 derives from. Here, n and k are each an integer of 1 or more, and n ≥ k.

Since the first identification mark 21 and the second identification mark 22 include information related to each other, the circuit substrate 210 or the dummy portion 215 and the individual substrate 300 can be managed in association with each other, and the range of traceability can be expanded. Accordingly, the individual substrate 300 is excellent in traceability.

Similarly to the first information and the second information, the fourth information included in the fourth identification mark 24 in the joined substrate 110 and the third information included in the third identification mark 23 may include information related to each other. That is, the "information related to each other" may be any information as long as it is possible to grasp that the fourth identification mark 24 and the third identification mark 23 belong to the same the joined substrate 110. Third information and fourth information included in the third identification mark 23 and the fourth identification mark 24 of the joined substrate 110 for obtaining the k-th circuit substrate 210 may include common unique information k. Thus, traceability from the joined substrate 110 (the metal plate 20) to the individual substrate 300 can be ensured.

The shape and size of the pair of the second conductor portion 42 in the individual substrate 300 may be the same or different. The second identification mark 22 may be provided only on the surface of one second conductor portion 42 or on the surface of both second conductor portions 42. If identification marks are provided on both of the second conductor portions 42, the front and back of the individual substrate 300 can be easily identified. The second conductor portion 42 on one surface side may constitute an electric circuit such as a power module, and the second conductor portion 42 on the other surface side may constitute a heat dissipation portion. For example, a semiconductor element may be mounted on the individual substrate 300. In this case, the second identification mark 22 may be exposed to the outside even after mounting. This makes it possible to ensure traceability even after mounting. An example of the individual substrate 300 is one in which the ceramic plate is made of aluminum nitride or silicon nitride and the second conductor portion 42 is made of copper or aluminum.

An example of a method for manufacturing the joined substrates 100 and 110 will be described. First, the ceramic plate 10 is prepared. The method for manufacturing the ceramic plate 10 includes a step of obtaining the ceramic plate 10 by irradiating a main surface of a ceramic base material with laser beam to form the division lines L1 and L2 dividing the main surface into a plurality of parts. The division lines L1 and L2 becomes cutting lines when the circuit substrate is divided in a subsequent process. The division lines L1 and L2 may be scribe lines. The scribe line may be formed by irradiating the surface of the ceramic base material with, for example, a carbon dioxide gas laser or a YAG laser.

The ceramic substrate can be obtained by firing a green sheet. The green sheet can be obtained by molding a slurry containing, for example, an inorganic compound powder, a binder resin, a sintering aid, a plasticizer, a dispersant, and a solvent. Examples of the inorganic compounds include silicon nitride (Si₃N₄), aluminum nitride (AIN), silicon carbide, and aluminum oxide. Examples of the sintering aid include rare earth metals, alkaline earth metals, metal oxides, fluorides, chlorides, nitrates, and sulfates. These may be used alone or in combination of two or more kinds thereof. By using the sintering aid, sintering of the inorganic compound powder can be promoted. Examples of the binder resin include methyl cellulose, ethyl cellulose, polyvinyl alcohol, polyvinyl butyral, and (meth)acrylic resins.

Examples of the plasticizer include phthalic acid plasticizers such as purified glycerin, glycerin trioleate, diethylene glycol, and di-n-butyl phthalate; and dibasic acid plasticizers such as di-2-ethylhexyl sebacate. Examples of dispersing agents include poly (meth)acrylates and (meth)acrylic acid-maleate copolymers. Examples of the solvent include organic solvents such as ethanol and toluene.

Next, the green sheet is degreased and sintered to obtain a ceramic substrate. The degreasing may be performed, for example, by heating at 400 to 800°C for 0.5 to 20 hours. Accordingly, it is possible to reduce the residual amount of organic matter (carbon) while preventing oxidation and deterioration of the inorganic compound. The sintering is performed by heating to 1700 to 1900°C in a non-oxidizing gas atmosphere such as nitrogen, argon, ammonia, or hydrogen. By processing the ceramic substrate thus obtained, the ceramic plate 10 as illustrated in FIG. 4 is obtained.

Next, the metal plates 20 and 30 are joined so as to cover the main surfaces 10A and 10B of the ceramic plate 10, respectively, to obtain the joined substrate 100. The metal plate 20 and the metal plate 30 are joined to one main surface 10A and the other main surface of the ceramic plate 10, respectively, via brazing material.

Specifically, first, a paste-like brazing material is applied to the main surface 10A and the main surface 10B of the ceramic plate 10 by a method such as a roll coater method, a screen-printing method, or a transfer method. The brazing material contains, for example, a metal component such as silver or titanium, an organic solvent, and a binder. The viscosity of the brazing material may be, for example, 5 to 20 Pa s. The content of the organic solvent in the brazing material may be, for example, 5 to 25% by mass, and the content of the binder may be, for example, 2 to 15 % by mass.

The metal plate 20 may have the third identification mark 23 and/or the fourth identification mark 24 on the surface 20A prior to being joined to the ceramic plate 10. Accordingly, the traceability of the metal plate 20 before joining can be ensured. The metal plate 30 may or may not have the same identification mark as that of the metal plate 20.

The metal plate 20 and the metal plate 30 are respectively stuck to the main surface 10A and the main surface 10B of the ceramic plate 10 to which the brazing material is applied. Thereafter, the ceramic plate 10 and the metal plates 20 and 30 are sufficiently joined by heating in a heating furnace to obtain the joined substrate 100 or the joined substrate 110. The heating temperature may be, for example, 700 to 900°C. The atmosphere in the furnace may be an inert gas such as nitrogen, and the heating may be performed under reduced pressure lower than atmospheric pressure, or under vacuum. The heating furnace may be of a continuous type in which a plurality of joined bodies are continuously manufactured, or may be of a type in which one or more joined bodies are batch-manufactured. The heating may be performed while pressing the joined body in the laminating direction.

In this example, the third identification mark 23 is provided on the surface 20A of the metal plate 20 before the ceramic plate 10 and the metal plates 20 and 30 are joined, but the sequence is not limited thereto. In a modification, the third identification mark 23 and the fourth identification mark 24 may be provided on the surface 20A of the metal plate 20 after the ceramic plate 10 and the metal plates 20 and 30 are joined. Accordingly, even when the brazing material oozes out to the outer edge portion of the surface 20A of the metal plate 20 at the time of joining, it is possible to sufficiently increase the reading accuracy of the third identification mark 23.

The fourth identification mark 24 located inside the third identification mark 23 is less likely to be affected by the oozing of the brazing material. For this reason, in another modification, only the fourth identification mark 24 may be provided on the surface 20A of the metal plate 20 before joining, and the third identification mark 23 may be provided on the surface 20A after joining.

A method for manufacturing a circuit substrate according to an embodiment includes performing at least an etching process on a joined substrate to form a first conductor portion and a second conductor portion in a dummy region and a circuit formation region, respectively, to obtain a circuit substrate including a dummy portion including the first conductor portion and a circuit formation portion including the second conductor portion. In this method for manufacturing, a joined plate including a ceramic plate having a main surface including a circuit formation region and a dummy region, and a metal plate joined to the ceramic substrate so as to cover the main surface is used. Examples of such a joined substrate include the joined substrate 100 of FIG. 1 and the joined substrate 110 of FIG. 7. Hereinafter, a case where the joined substrate 110 is used will be described as an example.

In this example, a step of removing portions of the metal plates 20 and 30 in the joined substrate 110 and forming the first conductor portion 41, the third conductor portion 43 and the second conductor portion 42 are formed in the dummy region 15 and the circuit formation region 16, respectively, to obtain the circuit substrate 210 is performed. This step may be performed by, for example, photolithography. Specifically, a photosensitive resist is printed on the surface 20A of the joined substrate 110. Then, a resist pattern having a predetermined shape is formed using an exposure apparatus. A similar resist pattern may be formed on the surface 30A of the metal plate 30. The resist may be a negative type or a positive type. Unnecessary resist is removed by, for example, cleaning.

After the resist pattern is formed, an etching process is performed to remove portions of the metal plate 20 and the metal plate 30 that are not covered by the resist pattern. Accordingly, the main surfaces 10A and 10B of the ceramic plate 10 are exposed in this portion. Thereafter, the resist pattern is removed. This results in the circuit substrate 210 of FIG. 8 including the dummy portion 215 and the circuit formation portion 216.

The circuit substrate 210 has the first identification mark 21 derived from the third identification mark 23 on the surface of the first conductor portion 41 placed in the dummy portion 215. Since there is such a first identification mark 21, the traceability is excellent. The circuit substrate 210 also has the second identification mark 22 derived from the fourth identification mark 24 on the surface of the second conductor portion 42 in addition to the first identification mark 21. Accordingly, the traceability can be ensured even after the circuit substrate 210 is divided along the division lines L 1 and L2.

Surface treatment of the surface 20A of the metal plate 20 of the joined substrate 110 may be performed. Examples of the surface treatment include chemical polishing in which a part of the surface 20A is dissolved and removed using a chemical agent. By such chemical polishing, for example, it is possible to remove foreign matter such as carbon attached to the surface 20A when manufacturing the joined substrate 110. In addition, the surface roughness can be increased to improve adhesion of the resist. In preparation for such a surface treatment, if the third identification mark 23 and the fourth identification mark 24 are formed in a recessed portion, the depth of the recessed portion may be greater than the depth of the recessed portion forming the first identification mark 21 and the second identification mark 22. The range of depth of each recessed portion is as described above. Accordingly, the reading accuracy of the first identification mark 21 and the second identification mark 22 in the circuit substrate 210 can be maintained sufficiently high.

The joined substrate 100 may be used instead of the joined substrate 110 to manufacture the circuit substrate 200 in the same manner as the circuit substrate 210. In a modification, the fourth identification mark 24 on the joined substrate 110 may be eliminated by surface treatment. Thus, it is possible to obtain a circuit substrate (that is, the circuit substrate 200) in which no identification mark remains on the surface of the second conductor portion 42 in the circuit formation portion 216. That is, the joined substrate 100 is manufactured by performing a surface treatment in which the fourth identification mark 24 disappears from the joined substrate 110 and the third identification mark 23 remains. Thereafter, by performing an etching treatment, the circuit substrate 200 having the first identification mark 21 derived from the third identification mark 23 can be obtained.

The surface of at least one of the first conductor portion 41, the second conductor portion 42, and the third conductor portion 43 of the circuit substrates 200 and 210 may be plated. The first identification mark 21 and the second identification mark 22 formed of the recessed portion can be traced using the first identification mark 21 and the second identification mark 22 even after plating. In a modification, a part of the surface of the first conductor portion 41, the second conductor portion 42, and the third conductor portion 43 (for example, a part where the first identification mark 21 and the second identification mark 22 are provided) may be covered with a protection layer such as a solder resist, and a plating film may be formed only on the other part of the surface.

A method for manufacturing an individual substrate according to one embodiment includes: a step of performing at least an etching process on a joined substrate to form a first conductor portion and a second conductor portion in a dummy region and a circuit formation region, respectively, to obtain a circuit substrate having a dummy portion including the first conductor portion and a circuit formation portion including the second conductor portion; and a step of separating the dummy portion from the circuit substrate to obtain an individual substrate including the second conductor portion. The step of obtaining the circuit substrate having the circuit formation portion may be as described in the method for manufacturing the circuit substrates 200 and 210 described above. Hereinafter, a case where the circuit substrates 200 and 210 are used will be described as an example.

The circuit substrates 200 and 210 are divided along the division lines L1 and L2 to separate the dummy portion 215 from the circuit substrates 200 and 210. The circuit formation portion 216 is divided for each section 18. Thus, an individual substrate having the second conductor portion 42 is obtained. If the circuit substrate 210 is used, the individual substrate 300 having the second identification mark 22 on the surface of the second conductor portion 42 as illustrated in FIG. 9 can be obtained. Such an individual substrate 300 can trace back information about manufacturing conditions by reading the second identification mark 22. For example, lot numbers, manufacturing information, quality information, and the like of the metal plate 20, the joined substrate 110, and the circuit substrate 210, and the like can be examined. This makes it possible to perform process management, quality management, and the like, so that the manufacturing method is excellent in traceability.

Although some embodiments of the present disclosure and modifications thereof have been described above, the present disclosure is not limited to the above-described embodiments and modifications thereof. For example, the shape of the second conductor portion 42 provided in each section 18 do not need to be the same, and each section 18 may have a different shape. Only one main surface of the ceramic plate may be covered with the metal plate. The shapes of the ceramic plate and the metal plate are not particularly limited. For example, in the joined substrates 100 and 110, four corner portions 11 of the ceramic plate 10 protrude outward from the corner portions of the metal plates 20 and 30, but only some of the corner portions 11 may protrude from the corner portion of the metal plates 20 and 30.

The number of each identification mark is not particularly limited. For example, the third identification mark 23 and the first identification mark 21 in the joined substrate 100 and the circuit substrate 200 may be one, or may be three or more. Two or more second identification mark 22 may be provided on the surface of one second conductor portion 42. The dummy portion 215 may be provided in a region other than the periphery of the circuit formation portion 216. For example, a dummy region may be provided between adjacent sections in the ceramic plate, and a conductor portion having a first identification mark may be provided in the dummy region to form a dummy portion.

The first identification mark 21, the second identification mark 22, and the fourth identification mark 24 may be configured such that a plurality of recessed portions are arranged in accordance with a predetermined rule, similarly to the third identification mark 23. The first identification mark 21, the second identification mark 22, and the fourth identification mark 24 may be two-dimensional barcodes, such as QR codes, similarly to the third identification mark 23. In addition, for example, the first identification mark 21, the second identification mark 22, and the fourth identification mark 24 may be three-dimensional codes using information regarding the depth of the recessed portion. The recessed portion may be a laser hole formed by a laser beam. As the laser source, for example, a carbon dioxide gas laser, a YAG laser or the like can be used.

### [Example]

The content of the present disclosure will be described in more detail with reference to examples, but the present disclosure is not limited to the following examples.

### [Formation of Two-Dimensional Code]

### (Example 1)

A first copper plate (thickness: 0.8 mm), a ceramic plate (silicon nitride plate, thickness: 0.32 mm), and a second copper plate were prepared. The first copper plate and the ceramic plate, and the ceramic plate and the second copper plate were respectively joined using a brazing material to obtain a joined substrate in which the first copper plate, the ceramic plate, and the second copper plate were laminated in this order. The surface of the first copper plate of the joined substrate was irradiated with laser beam to form a two-dimensional code (the third identification mark 23) formed of a plurality of laser holes (the recessed portions 23a) as illustrated in FIG. 2. A commercially available laser marker (manufactured by KEYENCE CORPORATION, trade name: MD-X1520) was used to form the two-dimensional code. The outline of the two-dimensional code was as follows. The laser beam irradiation conditions were as shown in Table 1.
Code type: DMX (ECC200)
Code size: 2.2mm × 2.2mm
Number of cells: 16 × 16
(Examples 2 to 12)

A two-dimensional code (the third identification mark 23) was formed on the surface of the first copper plate by the same procedure as in Example 1 except that the irradiation conditions of the laser beam were as shown in Table 1.

### [Evaluation of Two-Dimensional Code]

In each example, the depth of the laser hole constituting the two-dimensional code formed on the surface of the first copper plate was measured. For the measurement, a 3D shape measuring machine (manufactured by KEYENCE CORPORATION, model: VR-3000) was used. The measurement results were as shown in "Depth of Laser Hole (Before Treatment)" in Table 1. A fixed type code reader (manufactured by KEYENCE CORPORATION, model: SR-2000) was used to evaluate whether the two-dimensional code was readable. As a result, the two-dimensional codes of all of the examples were readable.

### [Surface Treatment of Joined Substrate]

A surface treatment was performed on the first copper plate and the second copper plate in the joined substrate of each example on which the two-dimensional code was formed. Specifically, a surface treatment agent containing hydrogen peroxide and sulfuric acid was used to dissolve a part of the surface layer of each copper plate to increase the surface roughness of the surface. Thereafter, the depth of the laser hole constituting the two-dimensional code was measured. The method was the same as that described in aforementioned [Evaluation of Two-Dimensional Code]. The measurement results are shown in "Depth of Laser Hole (After Treatment)" in Table 1.

**[Table 1]**

| | Laser Power | Scanning Speed | Pulse Frequency | Number of Repetition of Printing | Depth of Laser Hole (Before Treatment) | Depth of Laser Hole (After Treatment) |
|---|---|---|---|---|---|---|
| | [W] | [mm/sec] | [kHz] | [times] | [µm] | [µm] |
| Example 1 | 20 | 1000 | 30 | 50 | 15 | 13 |
| Example 2 | 20 | 2000 | 30 | 50 | 10 | 8 |
| Example 3 | 20 | 500 | 30 | 50 | 23 | 20 |
| Example 4 | 25 | 1000 | 30 | 50 | 25 | 23 |
| Example 5 | 15 | 1000 | 30 | 50 | 8 | 6 |
| Example 6 | 20 | 1000 | 50 | 50 | 12 | 11 |
| Example 7 | 20 | 1000 | 10 | 50 | 15 | 14 |
| Example 8 | 20 | 1000 | 30 | 15 | 5 | 4 |
| Example 9 | 20 | 1000 | 30 | 90 | 27 | 25 |
| Example 10 | 20 | 1000 | 30 | 1 | 3 | 1 |
| Example 11 | 20 | 2000 | 30 | 2 | 3 | 1 |
| Example 12 | 20 | 1000 | 30 | 5 | 4 | 2 |

It was confirmed that the two-dimensional code remained even after the surface treatment was performed. The depth of the laser hole tends to decrease after the surface treatment is performed. Accordingly, by increasing the depth of the laser hole, it is possible to prevent the occurrence of a reading error and improve the reading accuracy.

### Industrial Applicability

According to the present disclosure, it is possible to provide a circuit substrate and a method for manufacturing the same that are excellent in traceability. Further, it is possible to provide a joined substrate excellent in traceability. Yet further, it is possible to provide an individual substrate and a method for producing the same that are excellent in traceability.

### Reference Signs List

10: ceramic plate; 10A, 10B: main surface; 11: corner portion; 15: dummy region; 16: circuit formation region; 18: section; 18a: divided plate; 20, 30: metal plate; 20A, 30A: surface; 21: first identification mark; 22: second identification mark; 23: third identification mark; 24: fourth identification mark; 23a: recessed portion; 27, 37: outer edge; 41: first conductor portion; 42: second conductor portion; 43: third conductor portion; 52, 53: brazing layer; 100, 110: joined substrate; 200, 210: circuit substrate; 215: dummy portion; 216: circuit formation portion; 300: individual substrate; L1, L2: division line, VL: virtual line.

## Claims

1. A circuit substrate including a circuit formation portion and a dummy portion, the circuit substrate comprising:
a ceramic plate and a plurality of conductor portions joined to a main surface of the ceramic plate,
wherein the plurality of conductor portions include a first conductor portion provided on the dummy portion and a second conductor portion provided on the circuit formation portion, and
wherein a surface of the first conductor portion has a first identification mark.

2. The circuit substrate according to claim 1, wherein a part of an outer edge of the first conductor portion in the dummy portion surrounding the circuit formation portion protrudes outward from the main surface of the ceramic plate.

3. The circuit substrate according to claim 1 or 2, wherein the plurality of conductor portions includes a third conductor portion provided on the dummy portion and does not have the first identification mark.

4. The circuit substrate according to claim 1 or 2, wherein a surface of the second conductor portion has a second identification mark, and the second identification mark includes second information related to first information included in the first identification mark.

5. The circuit substrate according to claim 1 or 2, wherein the first identification mark includes a code formed of a laser hole, and the laser hole has a depth of 1 µm or more.

6. A joined substrate, comprising: a ceramic plate having a main surface including a circuit formation region and a dummy region; and a metal plate joined to the ceramic plate so as to cover the main surface,
wherein the metal plate has a third identification mark on a surface of a portion covering the dummy region.

7. The joined substrate according to claim 6, wherein a part of an outer edge of the metal plate protrudes outward from the main surface of the ceramic plate, and
wherein a corner portion of the ceramic plate protrudes outward from the metal plate.

8. The joined substrate according to claim 6 or 7, further having a fourth identification mark on a surface of a portion covering the circuit formation region, wherein the fourth identification mark includes fourth information related to third information included in the third identification mark.

9. The joined substrate according to claim 6 or 7, wherein the third identification mark includes a code formed of a laser hole, and the laser hole has a depth of 3 µm or more.

10. An individual substrate comprising a second conductor portion obtained by separating, from a circuit substrate including a dummy portion having a first conductor portion and a circuit formation portion having the second conductor portion, the dummy portion,
wherein a surface of the second conductor portion has a second identification mark including second information related to first information included in a first identification mark on the surface of the first conductor portion.

11. The individual substrate according to claim 10, wherein the second identification mark includes a code formed of a laser hole, and the laser hole has a depth of 1 µm or more.

12. A method for manufacturing a circuit substrate, the method comprising: a step of performing at least an etching process on the joined substrate according to claim 6 or 7 to form a first conductor portion and a second conductor portion on the dummy region and the circuit formation region, respectively, and to obtain a circuit substrate having a dummy portion including the first conductor portion and a circuit formation portion including the second conductor portion,
wherein the surface of the first conductor portion has a first identification mark derived from the third identification mark.

13. A method for manufacturing an individual substrate, the method comprising:
a step of performing at least an etching process on the joined substrate according to claim 6 or 7 to form a first conductor portion and a second conductor portion on the dummy region and the circuit formation region, respectively, to obtain a circuit substrate including a dummy portion including the first conductor portion and a circuit formation portion including the second conductor portion; and
a step of separating the dummy portion from the circuit substrate to obtain an individual substrate including the second conductor portion,
wherein the surface of the first conductor portion has a first identification mark derived from the third identification mark.
